# EUROPEAN PATENT SPECIFICATION

(11) **EP 1 825 346 B1**
(45) Date of publication and mention of the grant of the patent: **28.04.2010**
(21) Application number: 04806789.6
(22) Date of filing: 12.11.2004
(51) Int. Cl.: G06F 1/20, H05K 7/20, H02B 1/56, F28D 1/047

(54) **COOLING SYSTEM FOR ELECTRIC CABINETS**
KÜHLSYSTEM FÜR ELEKTRISCHE SCHALTSCHRÄNKE
SYSTEME DE REFROIDISSEMENT POUR ARMOIRE ELECTRIQUE

(43) Date of publication of application: 29.08.2007
(73) Proprietor: Stulz S.p.a., 37067 Valeggio s/M (IT)
(72) Inventor: PEROTTI, Paolo, I-37019 Peschiera d/G (IT)
(74) Representative: Petraz, Gilberto Luigi
(86) International application number: PCT/IT2004/000623
(87) International publication number: WO 2006/051562

(56) References cited:
- DE-C1- 19 641 552
- GB-A- 1 473 919
- US-B1- 6 167 947
- PATENT ABSTRACTS OF JAPAN vol. 010, no. 014 (M-447), 21 January 1986 (1986-01-21) & JP 60 175939 A (MATSUSHITA DENKI SANGYO KK; others: 01), 10 September 1985 (1985-09-10)
- PATENT ABSTRACTS OF JAPAN vol. 018, no. 127 (M-1569), 2 March 1994 (1994-03-02) & JP 05 312189 A (DAIKIN IND LTD), 22 November 1993 (1993-11-22)

## Description

### TECHNICAL FIELD

The present invention relates to a system for cooling electric cabinets.

More particularly, the invention relates to a cooling system that uses a heat exchanger designed to cool the electrical components mounted in the rack.

The unit was designed to optimise rack cooling processes and to increase the efficacy of the air flow within the rack compared to prior art systems by minimising the size of the unit without reducing performance and efficiency.

The invention applies to the electromechanical industry in general and, more specifically, to the field of apparatus for cooling racks or electric cabinets in general.

### BACKGROUND ART

It is known that electric cabinets containing electrical and electronic components, which are subject to overheating, must be cooled by suitable heat exchangers designed to cool the interior of the cabinets in order to prevent damage to the components.

In some cases, the heat exchangers are of the air-to-air type, that is to say, they consist of a pack of plates made from metal sheeting suitably folded to form a first air flow circuit and a second air flow circuit separate from each other.

Heat exchange occurs at the flat, front and rear surfaces of the plates which come into contact with the air that is forced into the two circuits by suitable fans.

The pack of plates is housed in a case in which there are also usually mounted a first fan unit that supplies air to the first circuit and a second fan unit that supplies air to the second circuit.

The case is usually mounted side by side with an electric cabinet at an opening that communicates with the interior of the cabinet itself. The case has a first pair of openings that place the first air flow circuit in communication with the interior of the cabinet and a second pair of openings that place the second air flow circuit in communication with the environment outside the cabinet.

The formation of the heat exchange pack involves difficulties and complications due essentially to the fact that each plate must have a pair of oppositely folded edges in order to form the required air flow circuits, one of the folded edges being designed to form a surface for guiding the air flow into the respective circuit, and to the fact that the last plate required to complete the pack has to be flat.

In other solutions, the cooling fluid used as heat medium is a liquid, usually water drawn directly from the mains and fed into heat exchangers which can thus supply cool air to the rack through suitable fans.

Both air and water heat exchangers have the disadvantage of creating insufficient heat exchange between the different layers of electrical components. Indeed, the air flows from the top down or from the bottom up and the electronic components themselves, which are mounted in horizontal layers, prevent the air fed in by the fans from circulating in the most effective manner.

This leads to non-uniform cooling which means that the components closest to the cool air inlet are correctly cooled, whilst those furthest away from the air inlet tend to overheat and are more likely to be damaged, with negative consequences that are not difficult to imagine.

Another serious risk involved in cooling the air inside a cabinet containing electronic components is condensation which may cause irreparable damage, leading to substantial economic loss owing to the high cost of the electronic components installed.

Condensation depends basically on the humidity of the air and leads to the formation of water droplets when there is an excessive difference between the temperature of the exchanger surface and the temperature of the air.

### DESCRIPTION OF THE INVENTION

This invention has for an object to overcome the drawbacks and disadvantages typical of prior art cooling systems and therefore to provide a heat exchanger for cooling electric cabinets that is equipped with a cooling unit capable of cooling as uniformly as possible the interior of the cabinet and the electrical components it contains.

This is accomplished by heat exchanger having the features described in the main claim.

The dependent claims described particularly advantageous embodiments of the invention.

The heat exchanger according to the invention is mainly characterised in that it is positioned at the back of the rack in such a way as to produce air flows in a horizontal direction that is always parallel to the electrical components, thus significantly improving cooling efficiency.

Indeed, the cooling unit, to be installed at the back of the cabinet, is designed to optimise air flow within the cabinet in order to keep the temperature and humidity parameters as constant as possible.

For this purpose, the cooling unit comprises a metal frame that houses the heat exchanger, which is made from copper pipes and cylindrical aluminium fins and which, under equal conditions of exchangeable heat power, occupies less space than a traditional exchanger with a straight profile.

The exchanger is crossed by an air flow produced by the centrifugal fan, which feeds cool air into the rack in a horizontal direction.

According to a feature of the invention, the air is sucked in by the centrifugal fan at the centre and forced back into the cabinet at the sides.

This produces an optimised air flow which comes into contact with the lateral surfaces of the electronic components mounted in the cabinet which are thus effectively cooled.

The operating principle whereby the air is cooled is the same as that of a traditional air-water or gas-liquid exchanger or of the evaporator unit of an air conditioner.

The warm air sucked in by the centrifugal fan is forced to flow around the finned surfaces of the exchanger in which the cooler heat medium is circulating.

Heat is transferred from the air to the heat medium, thus reducing the temperature of the air. The cooled air is allowed out through suitable side slots, whilst the heat medium, which instead becomes warmer, is cooled by means of an appropriate remote unit.

Document US-A-6167947 discloses a gas system for cooling electronic devices, in particular for cooling computer equipment. Said system comprises a sealed enclosure housing one or more heat generating devices, a blower and a heat exchanger. The enclosure is generally pressurized by dry nitrogen.

Patent Abstracts of Japan vol 010, no. 014 (M-447) & JP 60175939 A discloses an annular heat exchanger interposed between the blade and the fan casing of a fan. The motor of the fan is disposed outside of the casing.

GB-A-1473919 discloses a motor vehicle engine-cooling system including an annular heat exchanger matrix, a centrifugal fan positioned to draw air towards the centre of the annular heat exchanger and move it radially outwardly through the annular heat exchanger, a duct housing the annular matrix and centrifugal fan, whereby the matrix, fan and duct are fitted at the front of a vehicle.

### DESCRIPTION OF THE DRAWINGS

Other features and advantages of the invention will become evident on reading the following description of one embodiment of the invention, given as a non-restricting example, with the help of the enclosed drawings, in which:
- Figure 1 is a schematic representation of an electric cabinet equipped with a cooling unit according to the invention;
- Figure 2 is a schematic representation of the cooling unit fitted with the exchanger according to the invention;

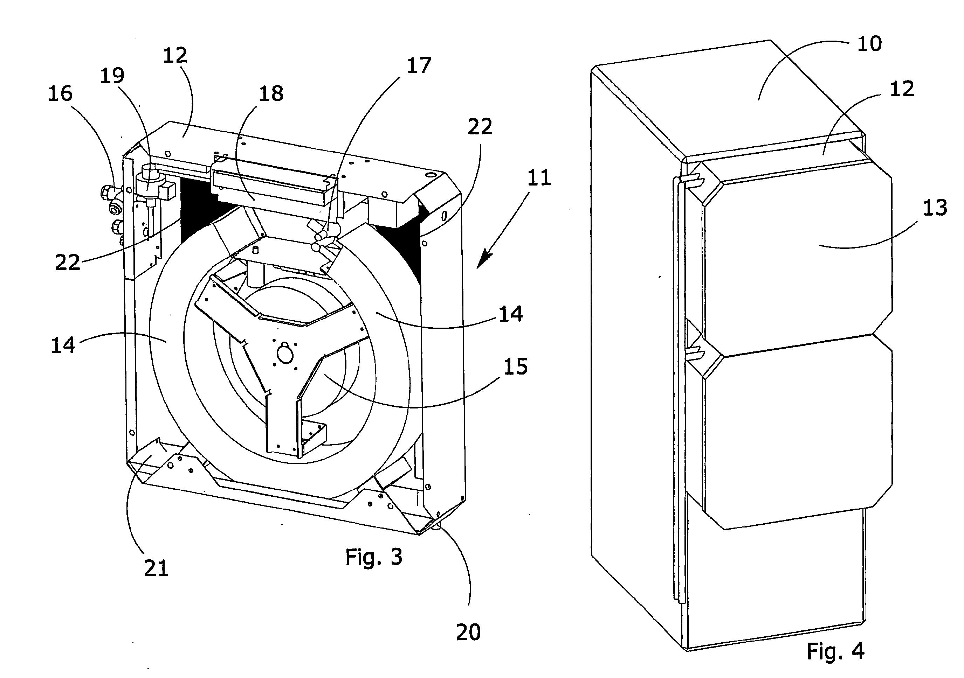

- Figure 3 shows a schematic view of the cooling unit comprised of the heat exchanger;
- Figure 4 schematically represents the back of a rack to which two modular cooling units have been applied;
- Figure 5 is a diagram representing the control performed by the machine;
- Figures 6 to 8 schematically represent the unit's operation using heat carrier fluids with three different configurations.

### DESCRIPTION OF A PREFERRED EMBODIMENT OF THE INVENTION

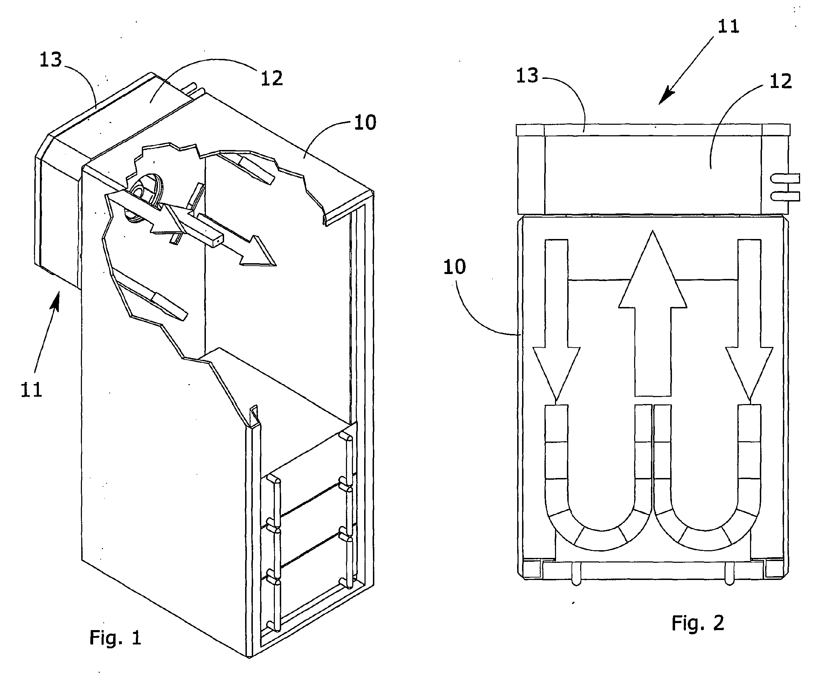

With reference first to Figure 1, the numeral 10 denotes in its entirety an electric rack cabinet equipped, at the back of it, with a cooling unit 11 according to the invention for cooling the cabinet.

The cooling unit 11 comprises a parallelepiped shaped frame 12, closed at the back by a cover 13 that is substantially the same size as the back of the cooling unit 11.

The rear cover 13 may be fastened to the exchanger frame 12 by any customary means, such as screws for example (not illustrated in the drawing).

The cooling unit 11 includes a substantially ringshaped heat exchanger 14 with a centrifugal fan 15 positioned coaxially inside it.

Outside and to one side of the frame 12 there are inlet and outlet valves 16 for the heat medium which may be any one of various heat carrying fluids designed to exchange heat with the air inside the cabinet.

The valves 16 are connected to the inlet and outlet connectors 17 located at one end of the heat exchanger 14.

Inside the heat exchanger 14 and above the fan 15 there are temperature and humidity sensors whilst an electronic control card 18 is located on the inside of the top of the frame 12.

The cooling unit is also equipped with a flow regulating valve 19 and a condensation drainage duct 20 leading to a drip tray 21.

It should be stressed that the heat exchanger 14 is made from copper pipes.and has cylindrical aluminium fins, which, under equal conditions of exchangeable heat power, occupies less space than a traditional exchanger with a straight profile.

Further, the side of the parallelepiped shaped frame 12 of the cooling unit 11 facing the rack 10 has air delivery apertures 22 made in the vicinity of its four corners.

The cooling unit 11 including the parts described above and closed by the cover 13, is installed next to an opening made in the electric cabinet 10 in such a way that the central suction opening and the air delivery slots 22 made in the front of the exchanger communicate with the opening made in the cabinet.

The cooling unit described is designed to be installed at the back of the rack cabinet 10 so as to optimise air flow within the cabinet in order to keep the temperature and humidity parameters as constant as possible.

Thus, as may be inferred from Figure 2, the air is sucked in at the centre by the central centrifugal fan 15 and forced back into the cabinet at the sides through the peripheral apertures 22.

This produces an optimised air flow which comes into contact with the lateral surfaces of the electronic components mounted in the cabinet 10, which are thus effectively cooled.

The operating principle whereby the air is cooled is the same as that of a traditional air-water or gas-liquid exchanger or of the evaporator unit of an air conditioner: The warm air sucked in by the centrifugal fan 15 is forced to flow around the finned surfaces of the exchanger 14 in which the cooler heat medium is circulating.

Heat is transferred from the air to the heat medium, thus reducing the temperature of the air. The cooled air is allowed to escape through suitable side slots, whilst the heat medium, whose temperature has been increased by the warm air flowing around the exchanger 14, is cooled by means of an appropriate remote unit.

The cooling unit is equipped with an electronic control system capable of precisely controlling temperature and humidity.

Indeed, the most serious risk involved in cooling the air inside a cabinet containing electronic components is the formation of condensation which may cause irreparable damage to the components.

Condensation depends basically on the humidity of the air and leads to the formation of water droplets when there is an excessive difference between the temperature of the exchanger surface and the temperature of the air.

The electronic control system according to the invention can control all the necessary parameters, especially those measured during the machine power up transient, when the temperature of the exchanger surface must not fall below the dew point.

For this purpose, the electronic card 18 enables the system to vary the opening of the flow regulating valve 19 and, if necessary, to decrease the speed of the fan 15 in order to reduce heat exchange.

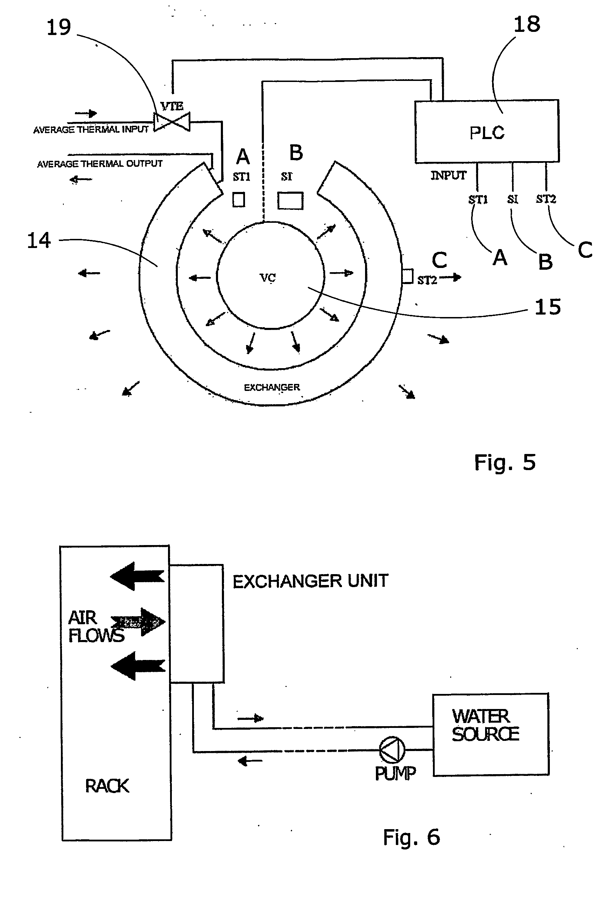

Figure 5 schematically represents this control system. More specifically, the electronic control card 18 has inputs, connected to an atmospheric air temperature sensor A, a humidity sensor B and an exchanger temperature sensor C.

Below is a brief description of an example of how the system can control a wide variety of temperature and humidity conditions.

First of all the sensors A and B detect the temperature and humidity parameters and send corresponding output signals to the electronic control card 18. Using dedicated software, the card 18 calculates the enthalpy of the air and accordingly sets the minimum temperature at which the exchanger without the risk of condensation being formed (dew point).

The card then detects the exchanger surface temperature through sensor C and compares it with the value calculated previously.

The cooling system is now adjusted accordingly, as follows:
If the temperature of the exchanger is lower than the dew point of the air sucked in, the control card may reduce the flow of heat medium within the exchanger by closing the opening of the flow regulator valve 19 or, if a direct current fan is being used, by adjusting the speed of the fan.
If the temperature of the exchanger is higher than the dew point, on the other hand, the card adjusts the opening of the flow regulator valve 19 in such a way as to optimise heat exchange.

Figures 6 to 8 illustrate examples of the unit's operation using heat carries fluids with the different configurations. The same exchanger unit can be used with different types of heat medium according to specifications.

Figure 6 illustrates system operation using water as the heat medium.

In this case, the water used for heat exchange may be drawn directly from the mains or from a chiller and is fed into the system by a suitable pump. This configuration offers excellent performance at reasonable costs.

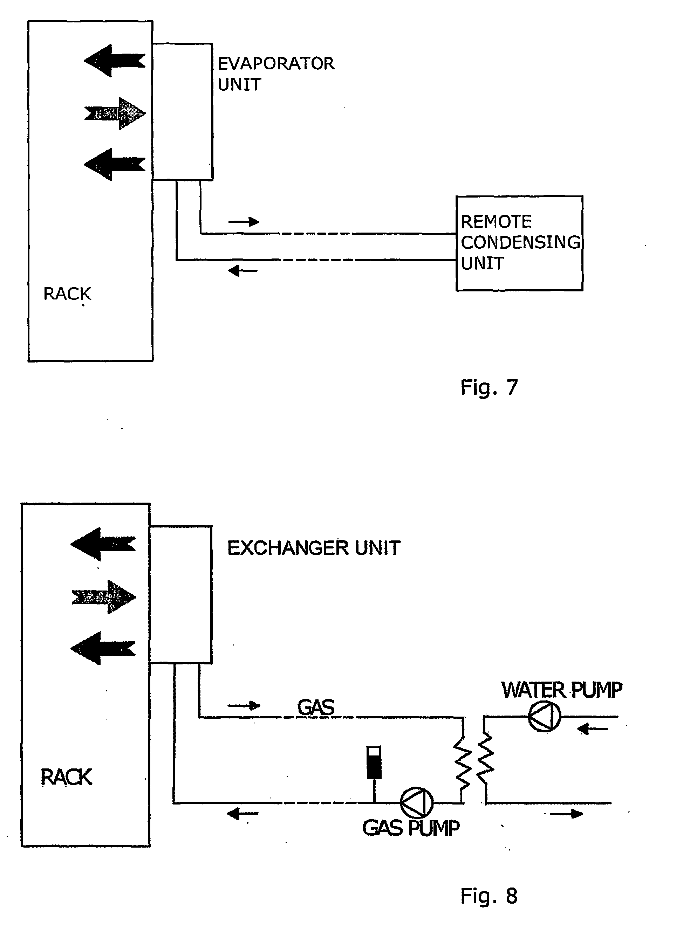

Figure 7 illustrates system operation using refrigerant gas as the heat medium.

This is the configuration used in air conditioning systems for buildings where the heat medium is a refrigerant gas, which has a high heat exchange coefficient, making it possible to achieve high performance levels.

It is based on a traditional cooling cycle, with an evaporator unit and a condensing unit.

The exchanger installed at the back of the cabinet functions like an evaporator unit: the fluid entering the exchanger comes into contact with the warm inside the cabinet and is turned into a gas and at the same time reduces the temperature of the air itself.

The function of the condensing unit, on the other hand, is the opposite: that is to say, it must turn the fluid back into the liquid state by transferring heat to the atmospheric air so that the fluid can be recycled.

The condensing unit may be installed either inside or outside the room where the cabinets are located. Outside installation has the advantage of not raising the temperature inside the room since the heat is dispersed to the outside atmosphere.

This configuration is the one that achieves the highest heat exchange values and, compared to water as the heat medium, has the advantage of eliminating the risk of damage to the components due to a possible leak in the pipes.

Lastly, Figure 8 illustrates system operation using refrigerant liquid as the heat medium.

It differs from the previous configuration in that the refrigerant fluid does not change state during the heat exchange cycle.

The fluid in the circuit is kept in the liquid state by pressure so that it can be made to circulate by means of a pump.

In this case, the liquid is cooled in a suitable gas-water exchanger so that it can return to the cabinet in order to cool the latter.

Thanks to the small size of the exchanger unit, more than one unit can be fitted to the same rack cabinet, thus achieving considerable heat exchange performance.

When two or more units are installed, the fluid circuits operate in parallel and may be controlled by a single electronic card.

To sum up, the cooling system according to the invention offers the following advantages:
- high performance in less space thanks to the ringshaped exchanger;
- optimised air flows inside the cabinet;
- possibility of monitoring the enthalpy of the air inside the cabinet and accordingly regulating the temperature of the exchanger and the speed of the fan;
- possibility of modular installations allowing the attainment of very high cooling power;
- possibility of installing the fluid cooling unit (gas-water) outside the room where the cabinets to be cooled are located (split solution).

In another embodiment of the invention, the apertures 22, instead of being between the exchanger and the rack, are made in the cover 13 so that the air from the rack is sucked in centrally and forced out of the unit through the exchanger and the holes in the cover. In this case, the air enters through the front of the rack 10 and flows out through the cover 13.

## Claims

1. A system for cooling electric cabinets or racks (10), comprising a cooling unit (11) constituted by a fan that generates air flows directed on heat exchangers allowing cooled air to be brought inside of a rack, **characterised in that** it said cooling unit (11) includes a ringshaped heat exchanger (14) inside of which a centrifugal fan (15) is coaxially mounted, whereby said heat exchanger (14), said centrifugal fan (15) and their component parts, are totally housed within a single metal frame (12) in a coaxial relationship in respect of each other, and **in that** the cooling unit (11) is positioned at the back of the rack (10) so as to produce horizontal air flows directed at the electrical components such that the air is sucked in by the centrifugal fan (15) at the centre and forced back into the cabinet (10) at the sides.

2. A cooling system for electric cabinets or racks (10) according to the preceding claim, **characterised in that** outside and to one side of the frame (12) there are inlet and outlet valves (16) for the heat medium constituted by the heat carrier fluid.

3. A cooling system for electric cabinets or racks (10) according to any one of the preceding claims, **characterised in that** inside the heat exchanger (14) and above the fan (15) there are temperature and humidity sensors, whilst an electronic control card (18) is located on the inside of the top of the frame (12).

4. A cooling system for electric cabinets or racks (10) according to any one of the preceding claims, **characterised in that** the cooling unit is equipped with a flow regulating valve (19) and a condensation drainage duct (20) leading to a drip tray (21).

5. A cooling system for electric cabinets or racks (10) according to any one of the preceding claims, **characterised in that** the heat exchanger (14) is made from copper pipes and has cylindrical aluminium fins.

6. A cooling system for electric cabinets or racks (10) according to any one of the preceding claims, **characterised in that** the side of the parallelepiped shaped frame (12) of the cooling unit (11) facing the rack (10) has apertures (22) made in the vicinity of its four corners designed to deliver air into the rack (10).

7. A cooling system for electric cabinets or racks (10) according to any one of the preceding claims, **characterised in that** the apertures (22), instead of being between the exchanger and the rack, are made in the cover (13) so that the air from the rack is sucked in centrally and forced out of the unit through the exchanger and the holes in the cover; the air, in this case, entering through the front of the rack (10) and flowing out through the cover (13).

## Patentansprüche

1. Kühlsystem für elektrische Schaltschränke oder -regale (10), mit einer Kühleinheit (11), die durch ein Gebläse ausgebildet ist, welches eine Luftströmung erzeugt, die auf Wärmetauscher gerichtet ist, so dass abgekühlte Luft nach innerhalb des Schaltschrankes zugeführt wird, **dadurch gekennzeichnet, dass** die Kühleinheit (11) einen ringförmigen Wärmetauscher (14) umfasst, in dessen Innerem ein Zentrifugalgebläse (15) koaxial montiert ist, wobei der Wärmetauscher (14), das Zentrifugalgebläse (15) und deren Bestandteile gemeinsam in einem einzigen Metallrahmen (12) in einer koaxialen Beziehung zueinander aufgenommen sind, und dass die Kühleinheit (11) an der Rückseite des Schaltschrankes (10) angeordnet ist, um so horizontale Luftströmungen zu erzeugen, die auf die elektrischen Komponenten gerichtet sind, so dass die Luft durch das Zentrifugalgebläse (15) im Zentrum angesaugt wird und an den Seiten in den Schaltschrank (10) zurück gedrückt wird.

2. Kühlsystem für elektrische Schaltschränke oder -regale (10) nach dem vorhergehenden Anspruch, **dadurch gekennzeichnet, dass** außerhalb und an einer Seite des Rahmens (12) Einlaß- und Auslaßventile (16) für das Wärmemedium vorgesehen sind, welches durch das Wärmeübertragungsfluid gebildet wird.

3. Kühlsystem für elektrische Schaltschränke oder -regale (10) nach irgendeinem der vorhergehenden Ansprüche, **dadurch gekennzeichnet, dass** innerhalb des Wärmetauschers (14) und oberhalb des Gebläses (15) Temperatur- und Feuchtigkeitssensoren vorgesehen sind, während eine elektronische Steuerungsplatine (18) an der Innenseite der Oberseite des Rahmens (12) platziert ist.

4. Kühlsystem für elektrische Schaltschränke oder -regale (10) nach irgendeinem der vorhergehenden Ansprüche, **dadurch gekennzeichnet, dass** die Kühleinheit mit einem Strömungsregulierungsventil (19) sowie mit einem Kondensationsableitungskanal (20) ausgestattet ist, der zu einer Tropfschale (21) führt.

5. Kühlsystem für elektrische Schaltschränke oder -regale (10) nach irgendeinem der vorhergehenden Ansprüche, **dadurch gekennzeichnet, dass** der Wärmetauscher (14) aus Kupferröhren hergestellt ist und zylindrische Lamellen aus Aluminium aufweist.

6. Kühlsystem für elektrische Schaltschränke oder -regale (10) nach irgendeinem der vorhergehenden Ansprüche, **dadurch gekennzeichnet, dass** die Seite des parallelepipedförmigen Rahmens (12) der Kühleinheit (11), die dem Regal (10) zugewandt ist, Öffnungen (22) aufweist, die daran in der Nähe der Ecken ausgebildet sind und derart vorgesehen sind, dass die Luft in das Regal (10) hinein gefördert wird.

7. Kühlsystem für elektrische Schaltschränke oder -regale (10) nach irgendeinem der vorhergehenden Ansprüche, **dadurch gekennzeichnet, dass** die Öffnungen (22), anstatt zwischen dem Wärmetauscher und dem Regal angeordnet zu sein, in der Abdeckung (13) ausgebildet sind, so dass die Luft aus dem Regal mittig eingesaugt wird und aus der Einheit durch den Wärmetauscher und die Öffnungen in der Abdeckung hinaus gedrückt wird; die Luft tritt in diesem Fall durch die Front des Regals (10) ein und strömt durch die Abdeckung (13) hinaus.

## Revendications

1. Système de refroidissement pour armoires ou de coffrets électriques (10), ledit système comprenant une unité de refroidissement (11) constituée par un ventilateur qui génère des flux d'air dirigés sur des échangeurs de chaleur permettant d'amener l'air refroidi à l'intérieur d'un coffret, **caractérisé en ce que** ladite unité de refroidissement (11) inclut un échangeur de chaleur (14) de forme annulaire à l'intérieur duquel un ventilateur centrifuge (15) est monté coaxialement, ledit échangeur de chaleur (14), ledit ventilateur centrifuge (15) et leurs composants étant entièrement logés à l'intérieur d'un unique châssis métallique (12) coaxialement l'un à l'autre, et **en ce que** l'unité de refroidissement (11) est positionnée au niveau de la face arrière du coffret (10) de manière à produire des flux d'air horizontaux dirigés sur les composants électriques de telle sorte que l'air est aspiré par le ventilateur centrifuge (15) au centre et renvoyé dans l'armoire (10) sur les côtés.

2. Système de refroidissement pour armoires ou coffrets électriques (10) selon la revendication précédente, **caractérisé en ce que** des clapets d'entrée et de sortie (16), destinés au milieu thermique constitué par le fluide caloporteur, sont prévus à l'extérieur et sur un côté du châssis (12).

3. Système de refroidissement pour armoires ou coffrets électriques (10) selon l'une quelconque des revendications précédentes, **caractérisé en ce que** des capteurs d'humidité et de température sont prévus à l'intérieur de l'échangeur de chaleur (14) et au-dessus du ventilateur (15), tandis qu'une carte de commande électronique (18) est placée du côté intérieur de la partie supérieure du châssis (12).

4. Système de refroidissement pour armoires ou coffrets électriques (10) selon l'une quelconque des revendications précédentes, **caractérisé en ce que** l'unité de refroidissement est équipée d'un clapet de régulation de flux (19) et d'un conduit d'évacuation de condensation (20) menant à un bac collecteur (21).

5. Système de refroidissement pour armoires ou coffrets électriques (10) selon l'une quelconque des revendications précédentes, **caractérisé en ce que** l'échangeur de chaleur (14) est fabriqué à partir de tuyaux de cuivre et possède des ailettes cylindriques en aluminium.

6. Système de refroidissement pour armoires ou coffrets électriques (10) selon l'une quelconque des revendications précédentes, **caractérisé en ce que** le côté du châssis parallélépipédique (12) de l'unité de refroidissement (11) qui est dirigé vers le coffret (10) possède des ouvertures (22) ménagées au voisinage de ses quatre coins afin de délivrer de l'air à l'intérieur du coffret (10).

7. Système de refroidissement pour armoires ou coffrets électriques (10) selon l'une des revendications précédentes, **caractérisé en ce que**, au lieu d'être placées entre l'échangeur et le coffret, les ouvertures (22) sont ménagées dans le capot (13) de sorte que l'air provenant du coffret est aspiré au centre et forcé à l'extérieur de l'unité via l'échangeur et les trous ménagés dans le capot ; dans ce cas, l'air entrant par la face avant du coffret (10) et circulant à travers le capot (13).
